(19) Europäisches Patentamt
European Patent Office
Office européen des brevets

(11) **EP 2 380 206 B1**

(12) **EUROPEAN PATENT SPECIFICATION**

(45) Date of publication and mention
of the grant of the patent:
**31.07.2013 Bulletin 2013/31**

(51) Int Cl.:
**H01L 31/0368** *(2006.01)*  **H01L 31/052** *(2006.01)*
**H01L 31/075** *(2012.01)*  **H01L 31/18** *(2006.01)*

(21) Application number: **10700561.3**

(22) Date of filing: **18.01.2010**

(86) International application number:
**PCT/EP2010/050528**

(87) International publication number:
**WO 2010/081902 (22.07.2010 Gazette 2010/29)**

(54) **Thin-film silicon tandem cell**

Dünnfilm-Tandemsiliciumzelle

Cellule tandem à film mince de silicium

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **19.01.2009 US 145614 P**
**05.06.2009 US 184459 P**

(43) Date of publication of application:
**26.10.2011 Bulletin 2011/43**

(60) Divisional application:
**13158302.3 / 2 602 833**

(73) Proprietor: **TEL Solar AG**
**9477 Trübbach (CH)**

(72) Inventors:
• **BAILAT, Julien**
**CH-2855 Glovelier (CH)**
• **LUCIE, Castens**
**CH-2000 Neuchâtel (CH)**

(74) Representative: **Troesch Scheidegger Werner AG**
**Schwäntenmos 14**
**8126 Zumikon (CH)**

(56) References cited:
**JP-A- 2008 060 605    US-A1- 2008 190 479**

• **DAS CHANDAN ET AL: "A constructive combination of antireflection and intermediate-reflector layers for a-Siâ Î 1/4 c-Si thin film solar cells", APPLIED PHYSICS LETTERS, AIP, AMERICAN INSTITUTE OF PHYSICS, MELVILLE, NY, US, vol. 92, no. 5, 8 February 2008 (2008-02-08), pages 53509-53509, XP012108130, ISSN: 0003-6951, DOI: DOI:10.1063/1.2841824**
• **BUEHLMANN P ET AL: "In situ silicon oxide based intermediate reflector for thin-film silicon micromorph solar cells", APPLIED PHYSICS LETTERS, AIP, AMERICAN INSTITUTE OF PHYSICS, MELVILLE, NY, US, vol. 91, no. 14, 2 October 2007 (2007-10-02), pages 143505-143505, XP012099595, ISSN: 0003-6951, DOI: DOI: 10.1063/1.2794423**
• **SHAH A ET AL: "Microcrystalline silicon and 'micromorph' tandem solar cells", THIN SOLID FILMS, ELSEVIER-SEQUOIA S.A. LAUSANNE, CH, vol. 403-404, 1 February 2002 (2002-02-01) , pages 179-187, XP004430351, ISSN: 0040-6090, DOI: DOI:10.1016/S0040-6090(01)01658-3**
• **PLATZ R ET AL: "Improved micromorph tandem cell performance through enhanced top cell currents", CONFERENCE RECORD OF THE 26TH IEEE PHOTOVOLTAIC SPECIALISTS CONFERENCE 19970929; 19970929 - 19971003 NEW YORK, NY : IEEE, US, 29 September 1997 (1997-09-29), pages 691-694, XP010267879, DOI: DOI:10.1109/PVSC.1997.654183 ISBN: 978-0-7803-3767-1**

EP 2 380 206 B1

• MEIER J ET AL: "Enhanced light-trapping for micromorph tandem solar cells by LP-CVD ZnO", CONFERENCE RECORD OF THE IEEE PHOTOVOLTAIC SPECIALISTS CONFERENCE 2002 INSTITUTE OF ELECTRICAL AND ELECTRONICS ENGINEERS INC. US; [IEEE PHOTOVOLTAIC SPECIALISTS CONFERENCE],, vol. CONF. 29, 19 May 2002 (2002-05-19), pages 1118-1121, XP010666477, DOI: DOI: 10.1109/PVSC.2002.1190802 ISBN: 978-0-7803-7471-3

**Description**

The present invention is directed to a thin-film silicon tandem cell which comprises a glass substrate, transparent to impinging light to be photovoltaically converted by the cell, thereon a top layer of transparent conductive oxide, thereon an amorphous silicon top cell, thereon a semi-transparent reflector layer, reflecting light predominantly in the spectrum of light with a wavelength of 500 - 750 nm and, thereon, a microcrystalline bottom cell. There follows - still in direction of impinging light - a bottom layer of transparent conductive oxide and, thereon, a white light reflector.

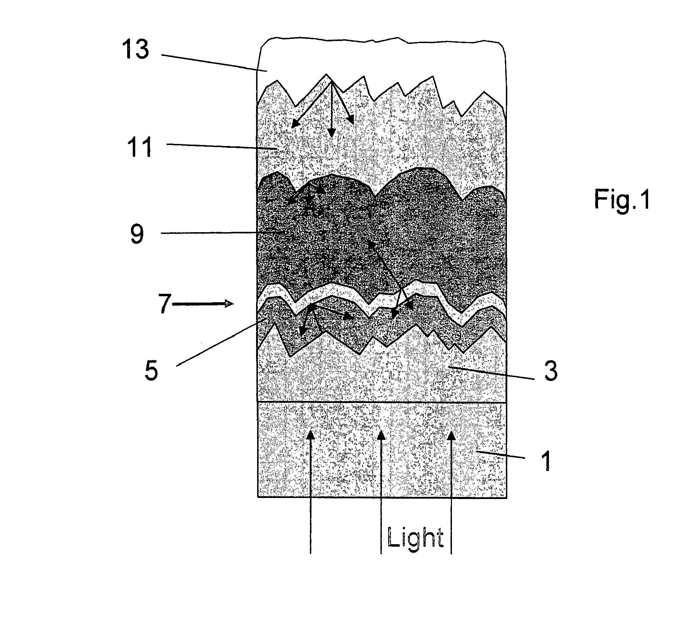

The structure of such a thin-film silicon tandem cell is shown schematically in fig. 1. According to fig. 1 a thin-film silicon tandem cell of the type addressed throughout the present invention comprises a glass substrate 1 whereupon the light to be photovoltaically converted impinges, as solar light.

On the glass substrate 1 there is provided a layer of transparent electrically conductive oxide 3. This layer is called front TCO layer. Upon the addressed layer 3, there resides the top cell 5 comprising a three-layer structure of a positively doped layer, an intrinsic layer and a negatively doped layer, p-i-n, which is an amorphous silicon cell.

We call a cell being an "amorphous silicon" cell if its i-layer, which is the photovoltaically active layer, is of amorphous silicon, irrespective of the conception of the negatively and of the positively doped layers of the cell.

Turning back to fig. 1 there may be seen that there resides upon the top cell 5 an amorphous silicon cell, an interlayer 7 which is a semi-transparent reflector layer. This layer 7 reflects light, thereby predominantly in the spectrum of light with a wavelength of 500 - 750 nm, back into the top cell 5. Upon the addressed semi-transparent reflector layer 7 there resides the bottom cell 9 which is a microcrystalline silicon cell. The bottom cell 9 comprises three layers, a positively doped layer, an intrinsic layer - which is the photovoltaically active layer - and a negatively doped layer. Thus, bottom cell 9 too has a p-i-n structure.

In analogy to an amorphous silicon cell we understand throughout the present description and claims under the term "microcrystalline silicon cell" a cell in p-i-n structure, wherein the intrinsic layer i is of microcrystalline silicon, irrespective of the conception of the positively and of the negatively doped layers.

Turning back to fig. 1, there follows upon the bottom cell 9 a bottom layer of transparent conductive oxide 11 and, finally, a white light reflector 13.

After being transmitted through the glass substrate 1 impinging light transits through the front TCO layer 3 and is, dependent on its surface characteristics at the interface to the top cell 5, scattered through the top cell 5. By such scattering the optical path through the top cell 5 is increased. Impinging upon the semi-transparent reflector layer 7 a part of the light which has transited through the top cell 5 transits towards and through the bottom cell 9, whereas a part of the light is scattered and reflected back into the top cell 5. Between the interface surface of the front TCO 3 and the top cell 5 on one hand and the interface surface between the semi-transparent reflector layer 7 and the addressed top cell 5, there occurs multiple reflection improving conversion efficiency in the top cell 5. Because the top cell 5 of amorphous silicon is effective for light in the spectral range according to a wavelength of about 500 - 750 nm, this spectrum of light is an important part of the light to be reflected by the semi-transparent reflector layer back into the top cell 5.

Light transiting through the semi-transparent reflector layer 7 is reflected on one hand at the interface surface between bottom TCO layer 11 and bottom cell 9 and, on the other hand, by the white reflector 13 back into the bottom cell 9.

The exploitation of a semi-transparent reflector layer 7 is known. We refer e.g. on D. Fischer et al. "The micromorph solar cell: extending A-SI:H technology towards thin-film crystalline silicon" in 25th PVSC; May 13-17, 1996; Washington D.C., to the EP 1 650 811, to J. Meier et al. "Latest R+D developments of thin-film silicon PV at Oerlikon Solar" in: "Proceedings of the 24. EU PVSEC, Valencia September 2008, Presentation 3CO. 7.1"

A further example of an intermediate reflector layer in a micromorph thin-film solar cell is giver in DAS chandan et al:" A constructive combination of antireflection and intermediate-reflector layers for a-Si/µcSi thin film solar cells", Applied Physics Letters, AIP, American institute of physics, vol. 92, no.5, 8 Febrary 2008.

Still with an eye on fig. 1 it should be noted that the index of refraction of the front and of the bottom TCO layer material is customarily about 2, whereas the index of refraction of the bottom cell 9 is customarily about 4. The index of refraction of the top cell 5 is about 4.5. Thus, to make the semi-transparent reflector layer 7 effective the index of refraction of its material has to be lower than the index of refraction of the adjacent top -5- and bottom -9- cells, should be lower than 2.5.

Optimizing such thin-film silicon tandem cell is a highly demanding task. This especially due to the fact that optimizing encompasses on one hand considerations of large-scale manufacturing, which should be at lowest possible prize and which is significantly governed by realized throughput and, on the other hand, photovoltaic conversion characteristics. Thus, it makes little sense to provide a photovoltaically highly effective tandem cell which may only be manufactured at very high costs, and, inversely, it makes little sense to provide for such tandem cell which may be manufactured at small costs, but which is of low photovoltaic conversion efficiency.

One aspect which significantly influences manufacturing costs is the thickness of layers which are exploited throughout the tandem cell structure. Thereby and especially if the thickness of the top and/or bottom cells are addressed and thereby of their photovoltaically active i layers, then there is an obvious tradeoff between lowering the respective thicknesses of these layers and of maintaining or even increasing conversion efficiency of the respective cells.

It is an object of the present invention to provide an improvement over existing tandem thin-film cells under consideration of both, manufacturing- as well as photovoltaic efficiency aspects.

Thereby, it is important to generically note that optimizing as mentioned above in this art addresses improvements in the low and lowest percentage ranges. This becomes understandable when considering the tremendous demand for photovoltaic conversion devices.

To resolve the object of providing further optimized thin-film tandem cells the tandem cell according to the present invention comprises

- a glass substrate which is transparent to impinging light to be photovoltaically converted by the cell; thereon

- a top layer of a transparent, conductive oxide; thereon

- an amorphous silicon top cell; thereon

- a semi-transparent reflector layer, reflecting light in the wavelength spectrum of 500 - 750 nm; thereon

- a microcrystalline bottom cell; thereon

- a bottom layer of transparent, conductive oxide; thereon

- a white light reflector, wherein

- the semi-transparent reflector layer is of an n-doped silicon oxide and has an index of refraction n below 1.7 and wherein

- the thickness of the amorphous silicon top cell is below 200 nm.

Thereby, in one embodiment the addressed index of refraction n is 1.68.

In a further embodiment of the thin-film silicon tandem cell the thickness d of the semi-transparent reflector layer is 30 nm or 50 nm and the current of the bottom cell is lower than the current of the top cell by a mismatch current $J\Delta$ of 0.5 mA/cm$^2$ and 0.5 mA/cm$^2$ respectively and the efficiency of the cell after 1000 h of light soaking under standard test conditions at AM 1.5 sun spectrum is between 10 and 10.5 %.

In one embodiment of the just addressed cell the light-induced degradation is below 8.5 %, and even below 8.2 %.

In a further embodiment of the addressed thin-film silicon tandem cell the light-induced degradation of the open circuit voltage $V_{oc}$ is between 1 and 2 %.

Still in a further embodiment of the thin-film silicon tandem cell according to the present invention, the silicon oxide of the semi-transparent reflector layer has an oxygen content of 57 % to 65 %.

Still in a further embodiment of the cell according to the present invention the top layer of a transparent conductive oxide is of low pressure chemical vapor - LPCVD - deposited ZnO and has a haze factor higher than 7 %, thereby in a further preferred embodiment, of 13 %.

In a further embodiment of the just addressed cell the thickness of the semi-transparent reflector layer is selected to be 30 nm or 50 nm.

In a further embodiment of the cell the thickness d of the semi-transparent reflector layer is selected between 5 and 150 nm, thereby preferably between 20 and 100 nm.

An example of a method for manufacturing a semi-transparent reflector layer between an amorphous silicon cell and a microcrystalline silicon cell of a tandem solar cell comprises depositing the reflector layer as a layer of n-doped hydrogenated silicon oxide n(SiO$_x$:H) by an Rf-PECVD process operated at an excitation frequency of about 40 MHz and at:

• a temperature of 150 - 250°C

• a pressure of 0.3 - 5 mbar

• a power density of 60 - 250 mW/cm$^2$

• during a time of 100 - 4000 sec.

EP 2 380 206 B1

and, if making use of an Oerlikon KAI-M plasma-enhanced chemical vapor deposition reactor as deposition tool, setting the following gas flows:

- $SiH_4$: 3 - 30 sccm

- $H_2$: 300 - 3000 sccm

- $PH_3$ in $H_2$, 2ppm: 50 - 500 sccm

- $CO_2$: 10 - 50 sccm,

thereby adapting the gas flow, if a different deposition tool is used, to such different deposition tool.

In one example of the addressed manufacturing method the pressure is set between 1 and 4 mbar, the power density between 100 and 200 $mW/cm^2$ and the following gas flows for the addressed KAI-M deposition tool are set:

- $SiH_4$: 4 - 15 sccm

- $H_2$: 500 - 2000 sccm

- $PH_3$ in $H_2$, 2ppm: 100 - 300 sccm

- $CO_2$: 10 - 30 sccm.

In a still further example of the addressed method the pressure is selected to be between 2 and 3 mbar and the power density between 100 and 170 $mWcm^2$, whereas time is set to be between 500 and 2000 sec. and the following gas flows are selected if making use of the addressed KAI-M deposition tool:

- $SiH_4$: 4 - 8 sccm

- $H_2$: 1400 - 1700 sccm

- $PH_3$ in $H_2$, 2ppm: 150 - 300 sccm

- $CO_2$: 15 - 25 sccm.

The invention under all its aspects shall now be further described by examples and referring to figures. The figures show:

Fig. 2    the efficiency after light soaking of three groups of tandem cells with different thicknesses of the top cell and, within the groups, different thicknesses of the semi-transparent reflector layer, as a function of current mismatch;

Fig. 3    in a representation analogous to that of fig. 2, the dependency of light degradation from current mismatch of tandem cells grouped in dependency of the thickness of the top cell, as of fig. 2;

Fig. 4    the tandem cells as addressed in the fig. 2 and 3 with respect to their loss of $V_{oc}$ by light soaking;

Fig. 5    the characteristics of a tandem cell according to the present invention;

Fig. 6    the characteristics of a tandem cell without providing an n-doped silicon oxide semi-transparent reflector layer according to the present invention;

Fig. 7    in dependency of oxygen content, the index of refraction of n-doped silicon oxide as applied for the semi-transparent reflector layer according to the present invention;

Fig. 8    as a function of wavelength, the total transmission and the diffused transmission of light for $SnO_2$ as of Asahi U and for ZnO, both as front TCO material for a tandem cell and co-defining the haze factor;

Fig. 9 the total reflection spectra of tandem cells according to the present invention deposited on commercial $SnO_2$ as front TCO without semi-transparent reflector layer ($p_3$), with a semi-transparent reflector layer of 30 nm thickness ($p_1$) and with a semi-transparent reflector layer of 50 nm ($p_2$) ;

Fig. 10 in a representation in analogy to that of fig. 9, the spectra for tandem cells according to the present invention, deposited on LPCVD-ZnO as front TCO material, whereby one spectrum represents a cell without semi-transparent reflector layer ($p_5$) and the second spectrum a tandem cell with semi-transparent reflector layer of 50 nm thickness ($p_4$) ;

Fig. 11 the reflection spectra of micromorph tandem cells according to the present invention with 50 nm thickness of the semi-transparent reflector layer, whereby the spectrum $p_6$ corresponds to a tandem cell deposited with LPCVD-ZnO front TCO and the spectrum $p_7$ corresponding to such tandem cell deposited with $SnO_2$ material as front TCO.

At first a Micromorph thin film silicon tandem cell with intermediate semi-transparent reflector layer deposited in an Oerlikon Solar KAI-M industrial reactor according to the present invention is described. The interlayer consists of n-doped silicon oxide. The best tandem cell on an Asahi transparent conductive oxide (TCO) glass reaches an efficiency of 10.4% after 1000 hours of light soaking. It is a slightly bottom limited cell under standard test conditions at AM1.5 sun spectrum. Without the semi-transparent reflector layer the $V_{oc}$ does not vary after light-soaking whereas it decreases by 2% when the semi-transparent reflector layer is incorporated. A very low degradation between 5 and 8.2% for different top cell thicknesses is achieved.

As was partly addressed above, the challenge in thin film silicon solar cells consists of absorbing most photons in the sun spectrum with the thinnest possible layers of active material. For thin film silicon devices indeed, thinner means better: better stable efficiency and shorter process times that eventually translate into lower cost per watt peak for solar modules.

Thinner active layers require however a strong effort on designing the solar cells to compensate for reduced light absorption and the resulting lower current-density. 'Advanced light management' consists of increasing the optical path of the light into the active layers of the tandem cell. For this purpose, and with an eye on fig.1, rough transparent conductive oxide (TCO) -3- that increases the 'optical thickness' of the absorbing layer is used. Further a semi-transparent reflector 7 is applied between the top -5- and bottom cell 9 to reflect high energy photon into high band-gap top cell -5- and transmit low energy photons into the low band-gap bottom cell 9. Finally, a rough transparent conductive oxide -11- with white dielectric paste -13- is added, to further increase the optical thickness of the bottom cell 9.

In the KAI-M plasma enhanced chemical vapor deposition (PECVD) reactor - used for the deposition of the complete tandem solar cell - doped silicon oxide based layers as semi-transparent reflector layers with refractive indexes below 1.7 are realized. No detrimental effects on the initial electrical parameters of the tandem solar cells result when the semi-transparent reflector layer 7 is introduced. After light-soaking however it is found that the open-circuit voltage $V_{oc}$ degrades by typically 1 to 2%, whereas that of the cells without semi-transparent reflector layers are stable. Also the behavior of the tandem cell efficiency after light-soaking with respect to the current-mismatch between the top and bottom cells is shown. For all tandem cells of the addressed type, also called Micromorph cells, and as realised today and investigated, the bottom cell -9- thickness is kept constant. The best device achieved today incorporating the semi-transparent reflector layer and according to the invention is slightly bottom limited with a stable efficiency of 10.4%.

The tandem cells with semi-transparent reflector layer 7 are produced in an Oerlikon Solar KAI-M PECVD reactor operating at an excitation frequency of 40Mhz and on Asahi glass coated with transparent conductive oxide layer 3. The cells are characterized by I-V curve measurements under standard test conditions with a sun simulator at AM1.5. The quantum efficiency (QE) curves of the top and bottom cells are used to estimate the current mismatch JΔ. It is expressed as the difference between the currents of the top and of the bottom cells - negative mismatch corresponding to top -5- limited cells and positive to bottom -9-limited cells. The refractive index of the semi-transparent reflector layers 7 is evaluated by the numerical fit of the transmission and reflection curves of the layer deposited on glass. The light-soaking process at a temperature of 50°C lasts 1000h with a light intensity of approximately $1000W/m^2$.

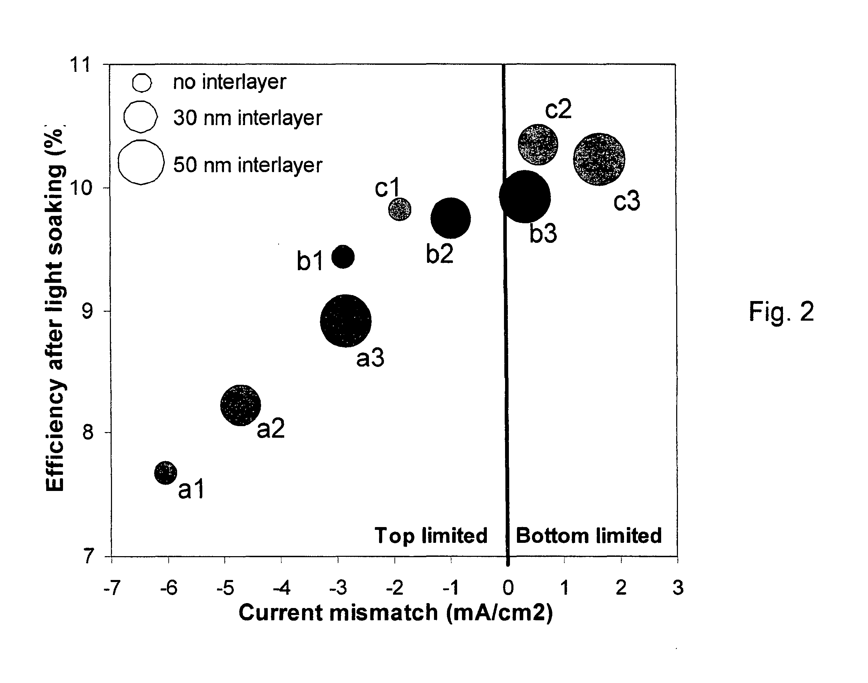

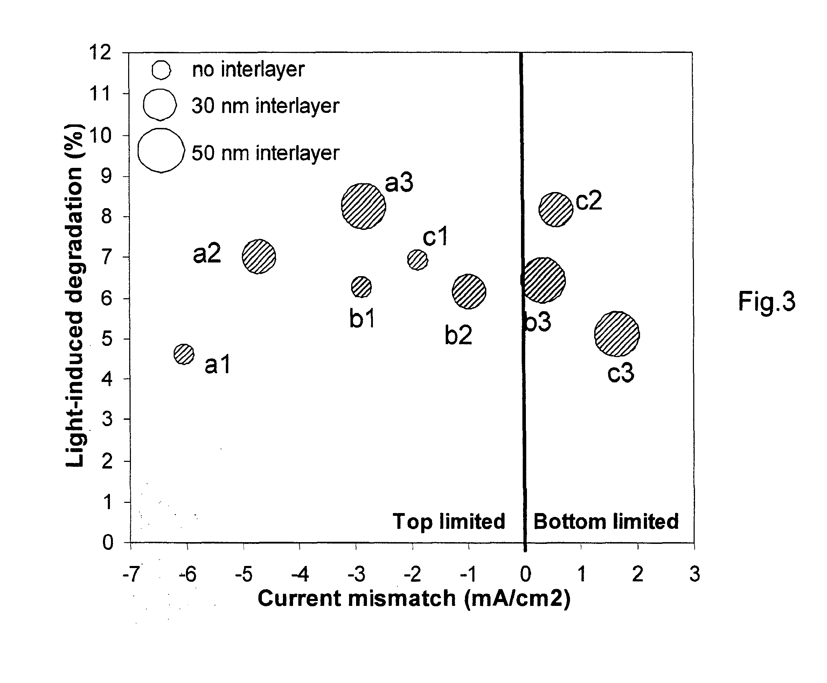

Two thicknesses of semi-transparent reflector layers are realised: 30 and 50 nm in different tandem cells with different top cell -5- thicknesses bellow 200 nm. When the semi-transparent reflector layer 7 is introduced, the quantum efficiency of the top amorphous solar cell 5 increases in the region from 500 to 750 nm. For sufficiently top-limited cells, this corresponds to an increase of the current of the tandem cell and eventually of the conversion efficiency. The behaviour of the tandem cells can be seen in Fig. 2 and Fig.3.

In these figures the term "interlayer" refers to the semi-transparent reflector layer 7 as of fig. 1 conceived of n-doped silicon oxide with an index of refraction n = 1.68.

The group addressed with $a_1$ to $a_3$ represents tandem cells with thinnest top cell 5. The group addressed with $b_1$ to $b_3$ addresses tandem cells with top cell 5 of increased thickness compared with group $a_1$ to $a_3$. Further, the group

of tandem cells represented by $c_1$ to $c_3$ are tandem cells whereat the thickness of the top cell 5 is increased with respect to the thickness of the tandem cells of group $b_1$ to $b_3$.

The current mismatch is defined as the difference of the current of the bottom cell from the current of the top cell according to

$$J\Delta \; = \; J_{QE\_top} - J_{QE\_bottom}$$

From fig. 2 it might be seen that the best cell efficiency results from a slightly bottom limited tandem cell and that thicker semi-transparent reflector layer 7 increases efficiency, provided that the bottom cell does not limit the cell too much.

From fig. 3 it might be seen that the light-induced degradation is below 8.2 %. Light soaking was performed during 1000 h under standard test conditions at AM 1.5 sun spectrum.

As compared to 30 nm thick semi-transparent reflector layer 7, the 50 nm one demonstrates a higher gain in top-cell current and efficiency, provided the tandem cell is sufficiently top limited. For a current mismatch of -6 mA/cm$^2$ (i.e. top-limited), the increase of efficiency is of 16% when a 50nm semi-transparent reflector layer 7 is inserted.

Fig. 3 represents the relative degradation after light soaking of the solar cells spanning from 5% to 8%. The low degradation is obtained thanks to the thin top cells 5 used in this study, all having a thickness below 200nm.

The best stable efficiency reaches 10.4% with the semi-transparent reflector layer 7. Low relative degradation of 8.2% for a slightly bottom limited solar cell with a 0.5 mA/cm$^2$ current-mismatch is reached. This confirms that the semi-transparent reflector layer 7 helps to fabricate more stable solar cells thanks to thinner top cell -5- active layers. But it could not help to increase the absolute efficiency of the solar cell as compared with cells without semi-transparent reflector layer, because we decided here to keep the bottom cell thickness parameter constant.

We can also fabricate cells with the same efficiency - and even slightly higher (10.6%) - without using the semi-transparent reflector layer (not shown here). The drawback is a thicker top cell 5 and a larger relative degradation under light soaking.

The presence of the semi-transparent reflector layer 7 initially improves the $V_{oc}$. After light soaking however the $V_{oc}$ of these cells degrades by as much as 2.4% resulting in little to no net gain as compared with the cells without such layer. On the other hand, the reference cells without semi-transparent reflector layer show little to no degradation of the $V_{oc}$ after the light soaking.

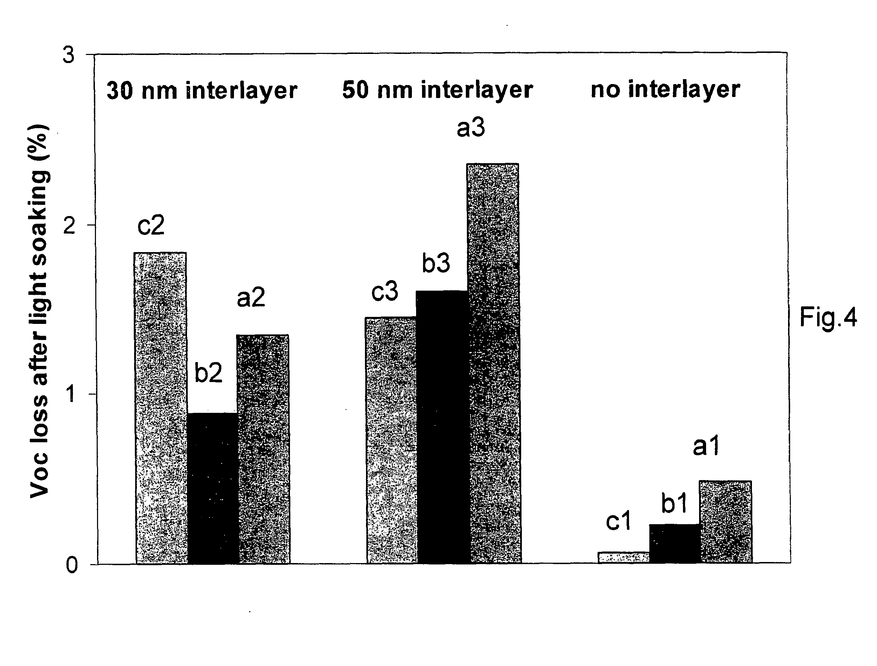

This is shown in fig. 4. Therein, the groups $a_1$ to $a_3$, $b_1$ to $b_3$ and $c_1$ to $c_3$ address the same groups which were defined in context with the figures 2 and 3.

Fig. 4 reveals a 1 to 2 % light-induced degradation of the open circuit voltage $V_{oc}$ for cells with the semi-transparent reflector layer 7 and no $V_{oc}$ loss without such layer 7.

If it was not for this $V_{oc}$ degradation, the stable efficiency of the best cell with the semi-transparent reflector layer 7 on Asahi substrate would be close to 10.6% and the relative degradation would be remarkably low with 6%. It is not yet fully understood the mechanism for this loss of $V_{oc}$. But the stability of the semi-transparent reflector layer based on doped silicon oxide may not be sufficient.

So up to now Micromorph tandem cells may be realised incorporating a semi-transparent reflector layer with a low refractive index n below 1.7 in a single chamber system equipped with a KAI-M PECVD reactor. Bottom limited cells reach a stable efficiency of 10.4% after 1000h of light soaking. Thanks to the introduction of the semi-transparent reflector layer, the efficiency loss after light-soaking is a moderate 8.2% for the best cells and even lower for the cells with a stronger current mismatch. It is reckoned that the absolute efficiency is still better without semi-transparent reflector layer with a value of 10.6% on Asahi substrate and, therefore, in this case, thinner is not really better, since we kept the bottom cell thickness constant.

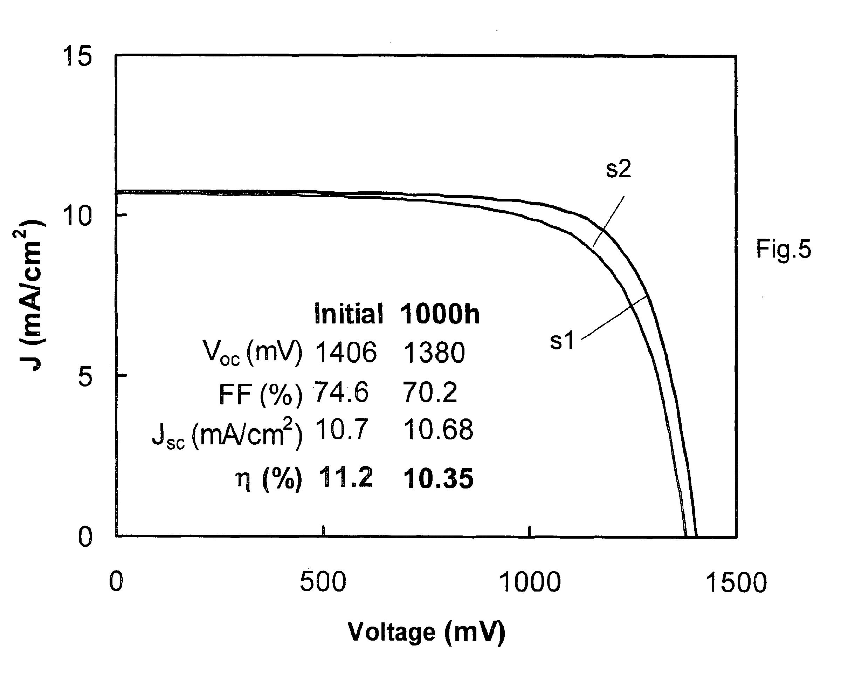

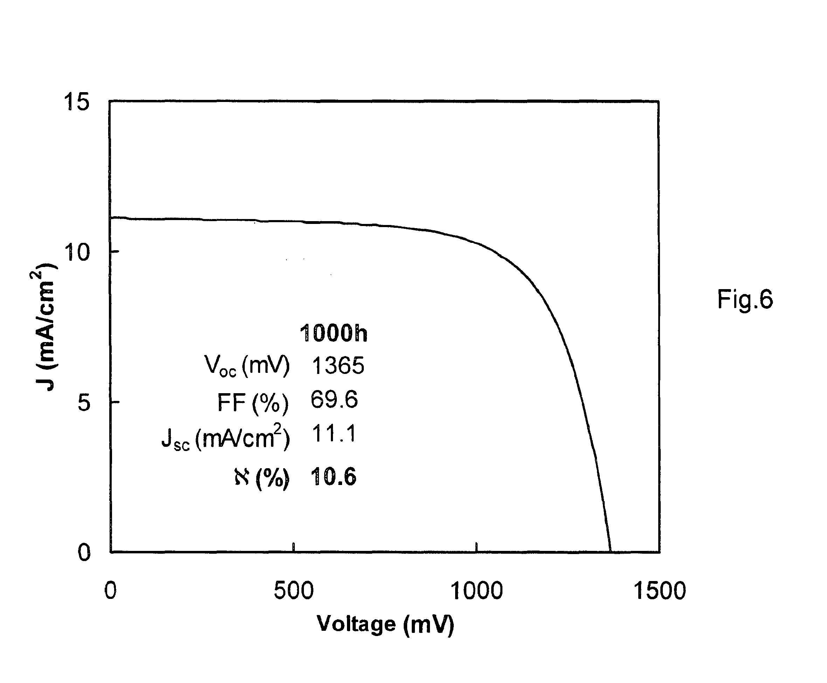

Fig. 5 shows the characteristic of such tandem cell according to the present invention deposited with a top TCO 3 of $SnO_2$ and Asahi glass substrate. This cell has a low relative light-induced degradation of 8.5 %. Fig. 6 shows for comparison purposes the tandem cell without provision of the n-doped silicon oxide semi-transparent reflector layer 7 with an index of refraction n < 1.7. In fig. 5 the characteristic $S_1$ shows the initial characteristic and the characteristic $S_2$ that after light soaking.

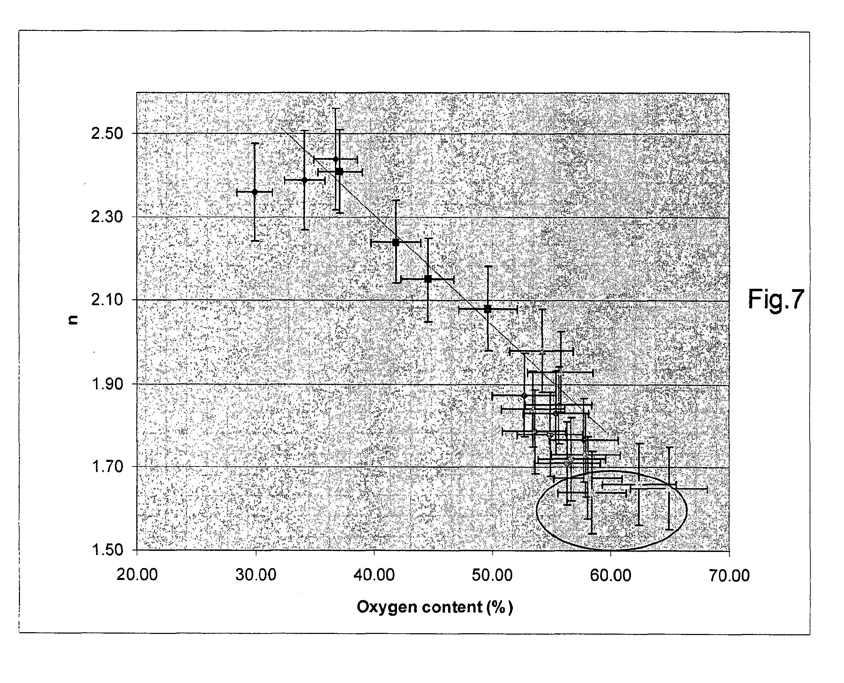

Further, the very low index of refraction of the material of the n-doped silicon oxide of the semi-transparent reflector layer was established by appropriately setting the oxygen content in the addressed material. Fig. 7 shows the dependency of the index of refraction n from the addressed oxygen content. Please note that the index of refraction below 1.7 exploited for the addressed material according to the present invention was achieved with an oxygen content in the addressed material between 57 % and 65 %.

As became apparent from the description up to now by providing according to the present invention the semi-transparent reflector layer it becomes possible to significantly reduce the thickness of the top cell. By such thickness reduction principally the opportunity is opened to reduce light soaking degradation of the tandem cell as caused by the top cell material.

Thereby, it has been recognized that the resulting tandem cells are bottom limited and may call for thicker bottom cells. An eye should be kept on the short and long term stability of the material of the semi-transparent reflector layer.

Nevertheless, the semi-transparent reflector layer as applied according to the present invention provides for sufficient out-of-plane conductivity larger than $10^{-5}$ S/cm and for low in-plane conductivity, which reduces shunting and obviates an additional need for laser-scribed patterning. The addressed layer provides for high transmission over visible and infrared wavelengths.

As was already addressed, the tandem cells were produced with a KAI-M reactor with a plasma excitation frequency of 40.68 MHz and the test cells were prepared by laser scribing to well-defined 1 cm$^2$.

We now proceed to investigating the behavior of the semi-transparent reflector layer in tandem cells with front TCO 3 of ZnO deposited by low-pressure chemical vapor deposition (LPCVD).

The thin film silicon tandem cells with n-doped silicon oxide based semi-transparent reflector layers were still deposited in the KAI-M industrial PECVD reactor as discussed. As was addressed, the implementation of the semi-transparent reflector layer between the top and the bottom cells increases the current of the top cell. From the optical analysis of the devices, specific features in the reflection spectrum attributed to the incorporated semi-transparent reflector layer can be observed. In particular, it has been recognised that there exists an influence of the transparent conductive oxide (TCO) layer roughness on the reflection spectrum of the cell. Reflection losses are reduced and photocurrents are increased by using rougher front TCO-layers namely of LPCVD-ZnO.

Thin-film silicon Micromorph tandem cells, composed of a top -3- amorphous (a-Si:H) p-i-n cell and a bottom -9-microcrystalline silicon p-i-n ($\mu$c-Si:H) cell allow reaching higher initial as well as higher stabilized efficiencies than single-junction cells. They preserve the advantages of thin-film silicon technology, such as the possibility of large-area deposition and monolithic series connection. The concept of the Micromorph tandem cells improves the conversion over the whole sunlight spectrum by the combination of a "high-bandgap" a-Si:H top cell, that absorbs efficiently visible light and the "low-bandgap" ($\mu$c-Si:H) bottom cell that converts efficiently the red and infrared part of the spectrum.

However and as was addressed, efficient multiple-junction devices demand careful engineering to balance the photocurrents of both the top and bottom cell while keeping the a-Si:H top cell rather thin to limit light-induced degradation. Several schemes of advanced light management are used for matching the current of the top and bottom cells while keeping the top cell thickness as thin as possible.

The cell as was described up to now is further to be improved.

To do so the optical path of the light into the active layers of the tandem cell is increased by applying a rough transparent conductive oxide (TCO) front contact. The increased optical thickness of the absorbing layers allows the top and bottom cells to be thinner. Secondly, a rough transparent conductive oxide back contact in combination with a white reflector further increases the optical thickness of the $\mu$c-Si:H bottom cell. The low-index semi-transparent reflector layer as deposited between the top and bottom cell reflects part of the light transmitted through the top cell. This combined approach allows to gain in top cell current and stability. If the tandem cell is not designed carefully, the light reflected by the semi-transparent reflector layer might not be efficiently absorbed in the top cell -5- and can be reflected out of the device. This loss by such reflection should therefore be minimized. This is achieved by applying a rougher LPCVD-ZnO (as-grown) front TCO instead of a less rough, commercial SnO$_2$.

Tandem cells as were addressed above have been deposited on commercially available SnO$_2$-coated glasses with a haze factor (diffuse transmission / total transmission) of 7% as well as on rougher as-grown ZnO front TCO layers 3 produced in a LPCVD (Low Pressure Chemical Vapour Deposition) reactor displaying a haze factor of 13%.

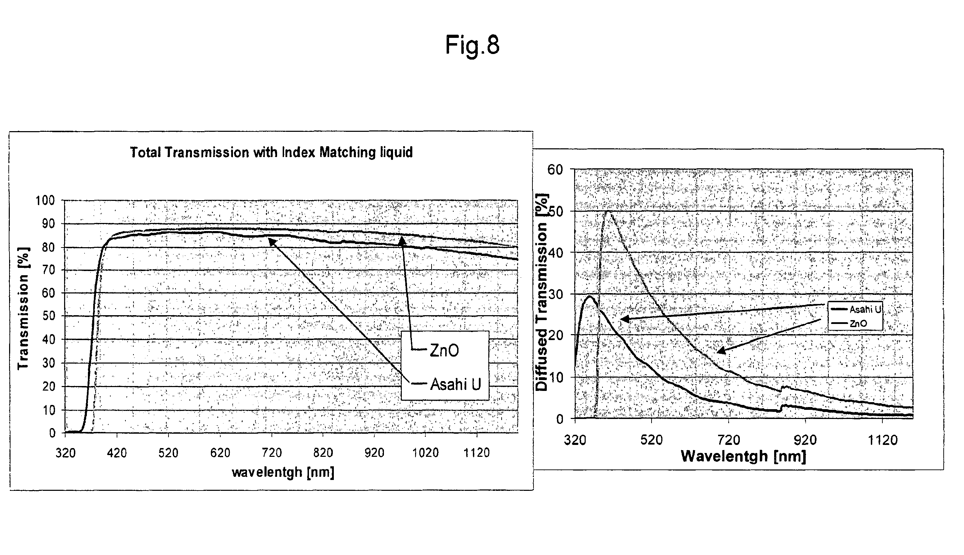

In fig. 8 the characteristics of total transmission measured with an index-matching liquid for low-pressure chemical vapour deposited rough ZnO and for commercially available SnO$_2$ is shown in dependency from wavelength of light as well as the characteristic of diffused transmission of these two addressed TCO materials over wavelengths. The characteristics of transmission and of diffused transmission in combination define for the addressed haze factor.

The tandem cells as investigated now were manufactured as addressed above, i.e. amorphous top cells, microcrystalline bottom cells and silicon oxide based intermediate reflectors have all been fabricated in the Oerlikon KAI-M plasma enhanced chemical vapor deposition (PECVD) reactor at at an excitation frequency of ca. 40 MHz. The intermediate reflector has been realized of n-doped hydrogenated Silicon oxide n(SiO$_x$:H). The PECVD process for deposition of the semi-transparent reflector layer 7 was performed at conditions shown in the table 1 below. The exact deposition frequency was 40.68 MHz; but other frequencies can be used. Deposition rates have been found to influence the reflection properties. The overall layer thickness for the semi-transparent reflector layer can vary between 5-150nm, preferably between 20-100 nm. Experiments with 30 and 50 nm have been performed. The oxygen content of the semi-transparent reflector layer influences the performance of the semi-transparent reflector layer, since an increase of oxygen in the layer will reduce the conductance, but will enhance transparency and reflection as shown in Fig.7. The thickness of the layer has been found to be less critical for the series resistance of the device.

Table 1

| Layer | Temp. [°C] | pressure [mbar] | SiH4 [sccm] | H2 [sccm] | PH3 in $H_2$ 2ppm [sccm] | CO2 [sccm] | Power Density [mW/cm$^2$] | Time [sec] |
|---|---|---|---|---|---|---|---|---|
| n(SiOx: H) | 150-250 | 0.3-5 | 3-30 | 300-3000 | 50-500 | 10-50 | 60-250 | 100-4000 |
| n(SiOx: H) | 150-250 | 1-4 | 4-15 | 500-2000 | 100-300 | 10-30 | 100-200 | 100-4000 |
| n(SiOx: H) | 200-250 | 2-3 | 4-8 | 1400-1700 | 150-300 | 15-25 | 100-170 | 500-2000 |

These values for the process for depositing the semi-transparent reflector layer are essentially applicable for essentially all known types of tandem solar cells of the a-Si/mc-Si i.e. of Micromorph type. The process parameter may vary depending on the deposition tool type, but will be readily adopted by a man skilled in the art. The first line in the table above represents the general embodiment, the second line a preferred embodiment and the third the further preferred set of parameters.

I-V characteristics under AM1.5 have been measured with a Wacom solar simulator. Spectral quantum efficiency (QE) measurements allow insight to the total photocurrent potential, more precisely the sum of top and bottom cell currents ($J_{sc}$(top) + $J_{sc}$(bot)), as well as the current mismatch, the difference of top and bottom cell currents ($J_{sc}$(top) - Jsc(bot)) under AM1.5 conditions. To observe the impact of the semi-transparent reflector layer in the tandem a co-deposited cell without a semi-transparent reflector layer 7 is used as reference device. Light-soaking was performed at a temperature of 50°C under approximately 1000W/m2 for 300 h up to 1000 h. The total reflection characteristics (specular & diffuse) of the tandem cell front side have been analyzed by a Perkin Elmer lambda 950 spectrometer equipped with an integration sphere.

Table 2 shows the current characteristics obtained by QE of different tandem cells prepared on commercial SnO$_2$- and of LPCVD-ZnO-TCO. Cells of same series (A or B) consist of cells with identical top and bottom cell thicknesses. Indeed, the bottom cell has been co-deposited on all top cells.

Table 2 shows in column 4 the overall current loss with the incorporation of the semi-transparent reflector layer.

Table 2

| | Cell without interlayer Total current [mA/cm$^2$] Jsc(top) & Jsc(bot) | Celll with 50nm interlayer Total current [mA/cm$^2$] | Difference Current loss [mA/cm$^2$] |
|---|---|---|---|
| **SnO$_2$ Serie A** | 19.99 | 19.19 | -0.8 |
| **LPCVD-ZnOSerieA** | 22.47 | 22.12 | - 0.35 |
| **SnO$_2$ Serie B** | 19.97 | 19.29 | -0.68 |
| **"LPCVD-ZnOSerie B** | 21.89 | 21.47 | -0.42 |

This table shows the impact on current densities determined by QE measurements of tandem cells deposited on SnO2 and LPCVD-ZnO with and without the semi-transparent reflector layer incorporated. Top cell thicknesses are identical for same series. Note, the reduction of current due to the interlayer in case of LPCVD-ZnO is less pronounced.

The results in Table 2 indicate that cells on LPCVD-ZnO reveal higher total currents compared to SnO$_2$ for both series. The current loss due to the semi-transparent reflector layer is lower in case of LPCVD-ZnO as front TCO. Thus, the results in Table 2 show that the properties of the front TCO in combination with a semi-transparent reflector layer play a fundamental role for light-trapping in the amorphous silicon top cell.

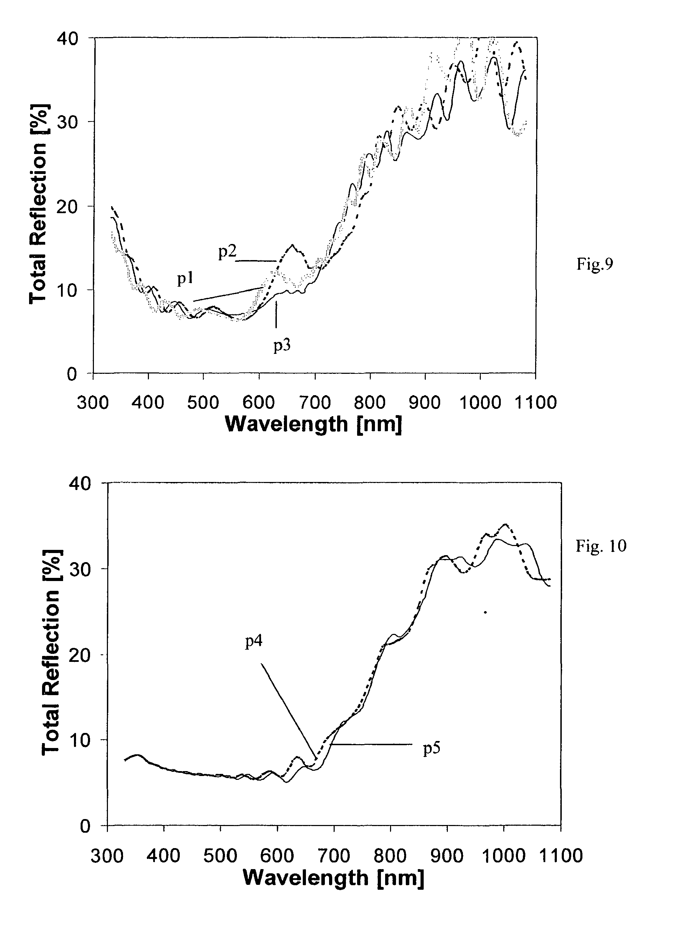

The reflection properties of tandem cells with and without semi-transparent reflector layers are given in Figure 9 and 10 for SnO$_2$, and for LPCVD-ZnO as front TCO. Two different semi-transparent reflector layers of 30nm and 50nm thickness have been studied for SnO$_2$, whereas in case of ZnO, a semi-transparent reflector layer of interlayer with 50 nm thickness.

Fig. 9 shows total reflection spectra of tandem cells deposited on a commercial SnO$_2$ coated substrate. The three spectra present cells without semi-transparent reflector layer, p3, with the semi-transparent reflector layer of 30 nm, p1, and with that layer of 50 nm, p2. Compared to the cell without semi-transparent reflector layer the reflection loss of light at ~ 650 nm wavelength increases with the thickness of the semi-transparent reflector layer as incorporated.

The presence of pronounced interference fringes is typical for commercial substrates with $SnO_2$ as front TCO. The reflection at ~ 650 nm clearly increases for the cell with 30 nm thick semi-transparent reflector layer and gets even more pronounced when the thickness of that layer is further increased to 50 nm.

Figure 10 shows total reflection spectra of tandem cells deposited on LPCVD-ZnO as front TCO (higher haze than $SnO_2$). The two spectra present cells without semi-transparent reflector layer, p5,and with the semi-transparent reflector layer of 50 nm thickness, p4. The semi-transparent reflector layer does not reveal a clear peak of reflection losses as can be observed on commercial $SnO_2$ in Fig. 9.

Thus in comparison, fig.10 reveals the total reflection of cells deposited on LPCVD-ZnO coated glass substrates. The comparison with Figure 9 indicates directly that the overall reflection characteristics are in case of ZnO reduced by about 2.5 %. In contrast to $SnO_2$ the cells on ZnO with 50 nm semi-transparent reflector layer have similar low reflection as the cells without such layer and only faint interference fringes are observed. Remarkably, the introduction of the semi-transparent reflector layer does barely increase the reflection in case of LPCVD ZnO as front TCO.

Results of best Micromorph tandem cells with the implemented semi-transparent reflector layer are given both for commercial $SnO_2$ as well as for LPCVD ZnO as TCO. The detailed solar cell parameters are summarized in Table 3 in the initial and light-soaked state (300 h).

Table 3 shows the initial and degraded characteristics of tandem cells with the semi-transparent reflector layer deposited on commercial SnO2 and on LPCVD-ZnO as front TCO.

Up to now, the best cell on commercial $SnO_2$ coated substrates and using the semi-transparent reflector layer achieve an initial efficiency of 11.27% and degrade down to 10.35% after both 300 and 1000 h of light-soaking. For this slightly bottom limited cell the current mismatch in the initial state is 0.57 mA/cm$^2$ (last column of Table 3). At present, for tandem cells with the semi-transparent reflector applied on LPCVD- ZnO (TCO) substrates, an initial efficiency of 11.19% is reached. This tandem cell has similar top and bottom cell thicknesses as in case of highest stabilized cell on $SnO_2$. On these - so far not fully optimized devices on LPCVD-ZnO - the current mismatch is more than twice that in the case of $SnO_2$ (1.23 mA/cm$^2$). Whereas open-circuit voltage and fill factors are slightly lower compared to $SnO_2$, current is higher for ZnO, both in the initial and light-soaked state. Thus, the cell with the rough LPCVD-ZnO as front TCO reaches an efficiency of 10.23% after 300 h of light-soaking that is very close to the 10.35% obtained on SnO2. There is observed a more pronounced decrease in $V_{oc}$ of 28mV compared to 15mV in case of $SnO_2$. The reason for that behaviour is not understood yet.

Table 3

| Cell with intermediate reflector | $V_{oc}$ [mV] | FF [%] | $J_{sc}$ [mA/cm$^2$] | Efficiency [%] | Mismatch $J_{top}$-$J_{bot}$ [mA/cm$^2$] |
|---|---|---|---|---|---|
| Cell on SnO$_2$ Initial | 1406 | 74.58 | 10.75 | 11.27 | 0.57 |
| Cell on SnO$_2$ Degraded 300h | 1391 | 69.84 | 10.66 | 10.35 | 0.41 |
| Cell on ZnO Initial | 1383 | 72.58 | 11.15 | 11.19 | 1.23 |
| Cell on ZnO Degraded 300h | 1355 | 69.26 | 10.9 | 10.23 | 1.08 |

The studies above show that Micromorph tandem cells on LPCVD-ZnO TCO-substrates reveal an overall lower total reflection characteristics compared to $SnO_2$ which indicates more efficient light-incoupling to the absorber. Furthermore, in case of $SnO_2$ as front TCO some additional reflection losses can be attributed to the application of the semi-transparent reflector layer, visible as increased interference fringes in the reflection spectra (Figure 9). This feature is not observed in the reflection spectra of cells on LPCVD-ZnO (Figure 10). Less pronounced interference fringes suggest again more efficient light-trapping and, thus, a higher current potential for the device. This fact is supported by the devices of Table 2, those reveal higher currents on LPCVD-ZnO. There is a good agreement between the spectroscopic reflection data and the response of the tandem cell devices.

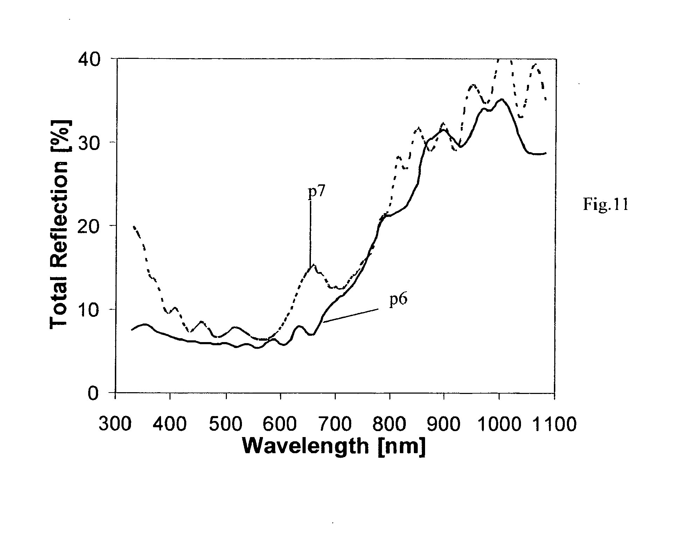

Figure 11 shows reflection spectra of Micromorph cells with 50nm semi-transparent reflector layer incorporated. Both tandems have the same top and bottom cell thicknesses. The lower curve, p6, corresponds to LPCVD-ZnO as front TCO, the upper one, p7, to SnO2.

The difference between the amplitude of the interference fringes in reflection spectra between 500 and 800nm of devices on $SnO_2$ and on ZnO (see figure 11) can be explained by the difference in the intensity of the specular part of light. Indeed, LPCVD-ZnO scatters the incoming light more efficiently (higher Haze) and probably also to higher angles. This results in decreased amplitude of the observed interference fringes for the solar cell deposited on the rougher LPCVD-ZnO as front TCO. Furthermore, the rough interface between the LPCVD-ZnO and the top cell reacts as a sort of index grading which reduces the overall reflection. In comparison, the smoother SnO2 coated glass with lower haze has a less pronounced index grading effect. It also transmits more light in the incident direction and, therefore, shows more pronounced interference fringes. The gain in the top cell is identical or even slightly higher in case of cells deposited on LPCVD-ZnO compared to those on $SnO_2$. Thus, one can suggest improving even further the roughness of the LPCVD-ZnO to access even better light-trapping.

The texture of the front TCO and its influence on the effectiveness of the semi-transparent reflector will need further investigation to achieve higher efficiencies. On the contrary applying rougher TCO demands some adaptation of the cell deposition processes to obtain good electrical performance in the device, both for amorphous top and microcrystalline bottom cells. Despite the slightly enhanced light-induced degradation of the $V_{oc}$-value on LPCVD-ZnO compared to $SnO_2$, which is a topic of further investigations, the efficiency of the Micromorph cell with the semi-transparent reflector layer after 300h light soaking is similar to the one on commercial TCO. While for the cell deposited on $SnO_2$ the mismatch is low, see table 3, the large difference between top and bottom currents for the tandem cell on ZnO suggests higher stabilized efficiencies.

It was shown that the introduction of a silicon-oxide based semi-transparent reflector layer in a Micromorph cell on commercial TCO leads to a loss in total current. The total current of tandem cells of same thicknesses deposited on rough LPCVD-ZnO is higher and presents a smaller loss when an semi-transparent reflector layer is introduced. This behavior is linked with reflection losses which in case of SnO2 substrates are higher and even more pronounced when an semi-transparent reflector layer is applied.

The reflection losses on LPCVD-ZnO are lower and are less influenced by the incorporation of the semi-transparent reflector layer. The current potential of tandem cells with the semi-transparent reflector layer on LPCVD ZnO is therefore higher than for cells on commercial $SnO_2$-TCO.

## Claims

1. A thin-film silicon tandem cell comprising:

   • a glass substrate (1), transparent to impinging light to be photovoltaically converted by the cell; thereon
   • a top layer (3) of a transparent conductive oxide; thereon
   • an amorphous silicon top cell (5); thereon
   • a semi-transparent reflector layer (7), reflecting light in the wavelength spectrum of 500 to 750 nm; thereon
   • a microcrystalline bottom cell (9); thereon
   • a bottom layer (11) of a transparent, conductive oxide; thereon a white light reflector (13),

   **characterised in that** said semi-transparent reflector layer (7) is of an n-doped silicon oxide and has an index of refraction n below 1.7, and the thickness of said amorphous silicon top cell (5) is below 200nm.

2. The cell of claim 1, wherein said n is 1.68.

3. The cell of claim 1, wherein said silicon oxide has and oxygen content of 57 to 65%.

4. The cell of claim 1, wherein said top layer of a transparent, conductive oxide is of LPCVD-deposited ZnO and has a haze factor higher than 7 %.

5. The cell of claim 4, wherein said haze factor is 13 %.

6. The cell of claim 5, wherein the thickness of said semi-transparent reflector layer is 30 nm or 50 nm.

7. The cell of one of claims 4 to 6, wherein thickness d of said semi-transparent reflector layer is between 5 and 150 nm, preferably between 20 and 100 nm.

## Patentansprüche

1. Eine Dünnschicht-Silizium-Tandem-Zelle umfassend:

   • ein Glassubstrat (1), welches durchsichtig ist für einfallendes Licht, das mittels der Zelle photovoltaisch umgewandelt werden soll; darauf
- eine obere Schicht (3) aus einem durchsichtigen, leitenden Oxid; darauf
- eine obere Zelle (5) aus amorphem Silizium; darauf
- eine halbdurchsichtige Reflektor-Schicht (7), welche Licht im Wellenlängenspektrum von 500 bis 750 nm reflektiert; darauf
- eine mikrokristalline untere Zelle (9); darauf
- eine untere Schicht (11) aus einem durchsichtigen, leitenden Oxid; darauf ein Weisslichtreflektor (13);

**dadurch gekennzeichnet, dass** die besagte halbdurchsichtige Reflektor-Schicht(7) ein n-dotiertes Siliziumoxid ist und einen Brechungsindex n kleiner als 1.7 hat, und die Dicke der besagten oberen Zelle (5) aus amorphem Silizium geringer als 200 nm ist.

2. Die Zelle nach Anspruch 1, wobei das besagte n gleich 1.68 ist.

3. Die Zelle nach Anspruch 1, wobei das besagte Siliziumoxid einen Sauerstoffgehalt von 57 bis 65% aufweist.

4. Die Zelle nach Anspruch 1, wobei die besagte obere Schicht aus einem durchsichtigen, leitenden Oxid aus LPCVDdeponiertem ZnO besteht und einen Trübungsfaktor höher als 7% aufweist.

5. Die Zelle nach Anspruch 4, wobei der besagte Trübungsfaktor höher als 15% ist.

6. Die Zelle nach Anspruch 5, wobei die Dicke der gesagten halbdurchsichtigen Reflektor-Schicht 30 nm bis 50 nm ist.

7. Die Zelle nach einem der Ansprüche 4 bis 6, wobei die Dicke d der besagten halbdurchsichtigen Reflektor-Schicht zwischen 5 und 150 nm, bevorzugt zwischen 20 und 100 nm, ist.

**Revendications**

1. Cellule tandem au silicium en film mince comprenant :

- un substrat en verre (1), transparent à la lumière qui le frappe pour être convertie de manière photovoltaïque par la cellule ; sur celui-ci
- une couche supérieure (3) en un oxyde conducteur transparent ; sur celle-ci
- une cellule supérieure en silicium amorphe (5) ; sur celle-ci
- une couche de réflecteur semi-transparente (7) réfléchissant la lumière dans le spectre de longueurs d'onde de 500 à 750 nm ; sur celle-ci
- une cellule inférieure microcristalline (9) ; sur celle-ci
- une couche inférieure (11) en un oxyde conducteur transparent ; sur celle-ci un réflecteur de lumière blanche (13),

**caractérisée en ce que** ladite couche de réflecteur semi-transparente (7) est en un oxyde de silicium n-dopé et présente un indice de réfraction n inférieur à 1,7, et l'épaisseur de ladite cellule supérieure en silicium amorphe (5) est inférieure à 200 nm.

2. Cellule selon la revendication 1, dans laquelle ledit n vaut 1,68.

3. Cellule selon la revendication 1, dans laquelle ledit oxyde de silicium présente une teneur en oxygène de 57 à 65 %.

4. Cellule selon la revendication 1, dans laquelle ladite couche supérieure en un oxyde conducteur transparent est en ZnO déposé par LPCVD et présente un facteur de voile supérieur à 7 %.

5. Cellule selon la revendication 4, dans laquelle ledit facteur de voile est de 13 %.

6. Cellule selon la revendication 5, dans laquelle l'épaisseur de ladite couche de réflecteur semi-transparente est de 30 nm ou de 50 nm.

7. Cellule selon l'une des revendications 4 à 6, dans laquelle l'épaisseur d de ladite couche de réflecteur semi-transparente est comprise entre 5 et 150 nm, de préférence entre 20 et 100 nm.

Fig. 2

Fig.3

EP 2 380 206 B1

Fig.4

Fig.5

|  | Initial | 1000h |
|---|---|---|
| $V_{oc}$ (mV) | 1406 | 1380 |
| FF (%) | 74.6 | 70.2 |
| $J_{sc}$ (mA/cm$^2$) | 10.7 | 10.68 |
| η (%) | 11.2 | 10.35 |

EP 2 380 206 B1

Fig.6

1000h

| | |
|---|---|
| $V_{oc}$ (mV) | 1365 |
| FF (%) | 69.6 |
| $J_{sc}$ (mA/cm$^2$) | 11.1 |
| ℵ (%) | 10.6 |

Fig.7

## Fig.8

Fig.9

Fig. 10

Fig.11

## REFERENCES CITED IN THE DESCRIPTION

**Patent documents cited in the description**

- EP 1650811 A, J. Meier

**Non-patent literature cited in the description**

- **D. FISCHER et al.** The micromorph solar cell: extending A-SI:H technology towards thin-film crystalline silicon. *25th PVSC,* 13 May 1996

- **DAS CHANDAN et al.** A constructive combination of antireflection and intermediate-reflector layers for a-Si/$\mu$cSi thin film solar cells. *Applied Physics Letters,* 08 February 2008, vol. 92